# EUROPEAN PATENT SPECIFICATION

(11) **EP 2 809 841 B1**
(45) Date of publication and mention of the grant of the patent: **25.04.2018**
(21) Application number: 13707057.9
(22) Date of filing: 25.01.2013
(51) Int. Cl.: D06M 11/83, C23C 14/00, H01J 37/34, D06M 11/44, D06M 11/46, C23C 14/34, C23C 14/35, C23C 14/56, C23C 28/02, C23C 28/00, H01J 37/32, H05K 9/00, C23C 14/20

(54) **TEXTILE PRODUCT FOR ATTENUATION OF ELECTROMAGNETIC FIELD**
TEXTILPRODUKT ZUR DÄMPFUNG VON ELEKTROMAGNETISCHEN FELDERN
PRODUIT TEXTILE PERMETTANT UNE ATTÉNUATION DU CHAMP ÉLECTROMAGNÉTIQUE

(30) Priority: 02.02.2012 PL 39797712
(43) Date of publication of application: 10.12.2014
(73) Proprietor: Instytut Wlokiennictwa, 92-103 Lódz (PL); Politechnika Wroclawska, 50-370 Wrocklaw (PL)
(72) Inventor: KOPROWSKA, Joanna, PL-91-849 Lodz (PL); KUSIAKIEWICZ, Janusz, PL-42-200 Czestochowa (PL); SZWUGIER, Arkadiusz, PL-93-277 Lodz (PL); JEGIER, Grzegorz, PL-91-230 Lodz (PL); ZIAJA, Jan, PL-50-422 Wroclaw (PL)
(74) Representative: Witek, Rafal
(86) International application number: PCT/PL2013/000006
(87) International publication number: WO 2013/115660

(56) References cited:
- WO-A1-2006/030254
- DE-A1- 3 436 097
- US-A1- 2005 039 937

## Description

The subject of this invention is a textile product which attenuates electromagnetic field, whereby the textile products are intended for the applications such as electromagnetic field shields, used especially in hospitals, office blocks, dwelling houses and laboratories, and which may be used for manufacturing of wallpaper, curtains, blinds and roller blinds.

The method and the device for coating a substrate with a transparent layer of a metal oxide in magnetron sputtering process are known from the German patent application No. DE102008034960. The method consists in that the substrate to be coated is transferred with a conveying device through the holes made in the device chamber, whereby, the layers of tin, zinc, cadmium, gallium, indium as well as compounds, especially oxides, and mixtures of these materials are deposited on the substrate by magnetron sputtering method. The device has a chamber equipped with a magnetron sputtering device, a conveying device for transferring a substrate to be coated and pipe cathodes.

A method of manufacturing the fabrics protecting against UV- and electromagnetic waves is known from the Chinese patent application No. CN1970882. The method consists in that the woven fabric to be coated is washed with detergent, rinsed in clean water, dried and smoothed. Then, the woven fabric is inserted in the vacuum chamber equipped with a device for magnetron sputtering of a coating onto woven fabrics, whereby the deposition process of the coating is carried out in the temperature range of 0 to 150°C, at a pressure from 0.4 10⁻² to 100 Pa, at a sputtering power from 20 to 400 W, for 5 60 min. Metals deposited as the coatings are aluminium, silver, iron, nickel, chromium, gold, platinum or magnesium, mixtures of the metals and their compounds, especially oxides and nitrides.

The subject of the invention is a textile product attenuating electromagnetic field, in a form of a substrate with a sputtered metal coating, characterized in that the substrate has a deposited coating consisting of at least one layer (L₁, L₂, L₃, L₄) of Zn-Bi composite, wherein said layer has a thickness below few micrometers [µm], whereby the layers (L₁, L₂, L₃, L₄) are deposited on the substrate alternately, and the number of deposited layers (L₁, L₂, L₃, L₄) depends on the coefficient of shielding efficiency of electromagnetic field by the textile product, whereby the substrate is made of woven or nonwoven fabric of polypropylene, polyester, polyolefine, polyamide, aramid or polyacrylonitrile.

The textile product has high stability and a small thickness of its fibres makes possible to fill completely the whole surface of a material transferred across the convex anode during the sputtering process. The sputtering process is carried out at a relatively low temperature and does not damage the textile material. The using of electromagnetic clutches, operating in vacuum and adjusting the transfer speed of a substrate, makes possible to achieve a suitable tension of the substrate during sputtering which, in turn, assures uniform coating of the substrate forming conducting mesh, ensuring satisfactory attenuation of electromagnetic field. Furthermore, the device is equipped with a supplying system ensuring power modulation, which can be precisely controlled within the range of 0 100% in order to avoid partial melting of the textile material in the plasma zone at high pulses of energy transferred in a short period of time. The device is also equipped with a computer system for recording of technological parameters, which enables repeatable performation of the sputtering process, especially in case of textile materials.

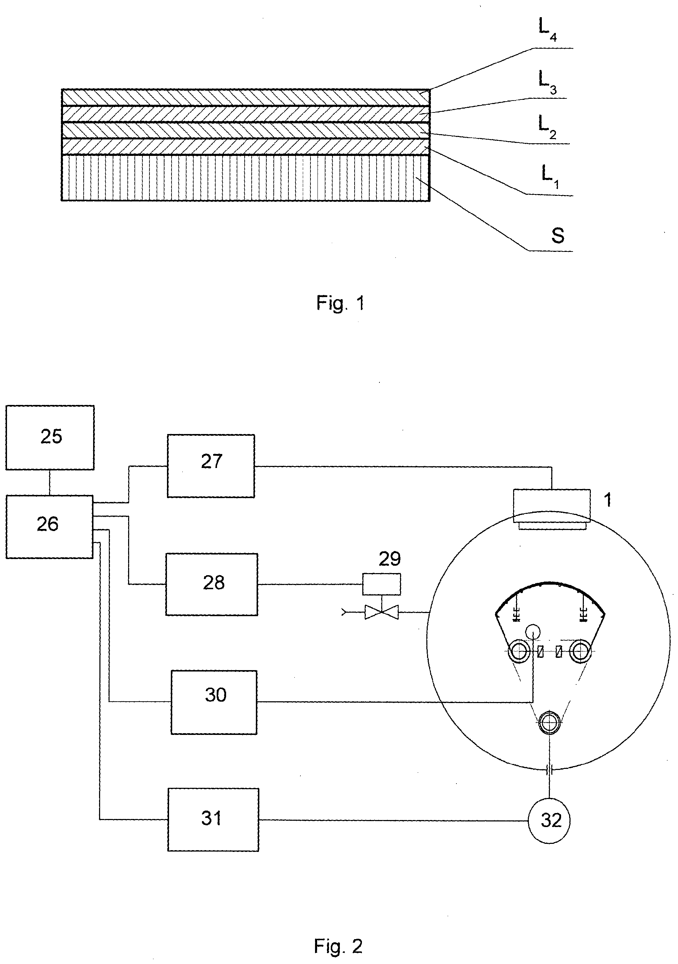

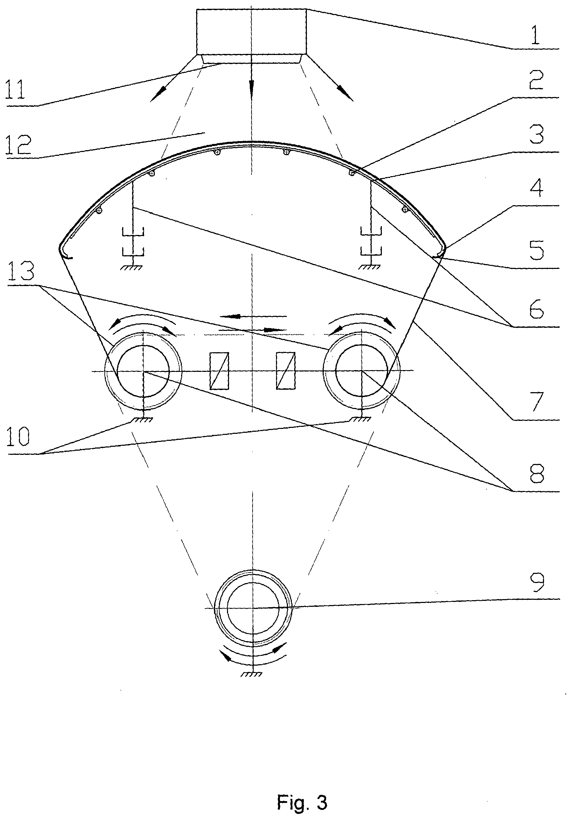

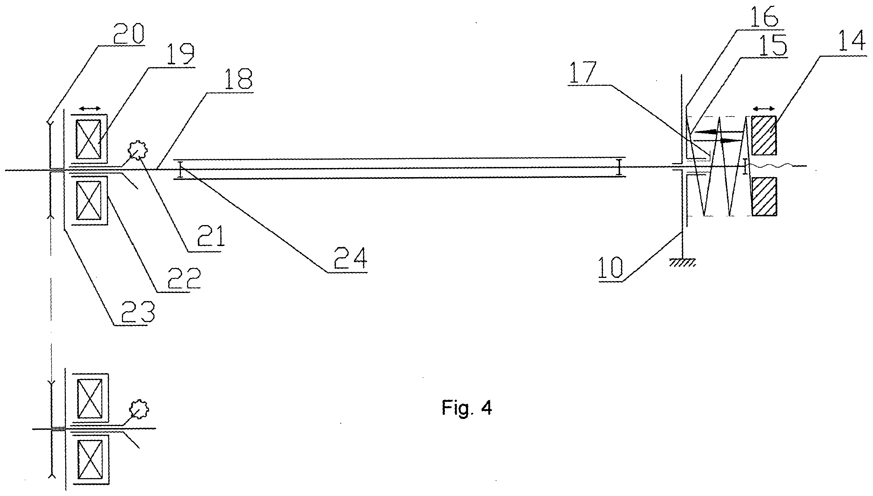

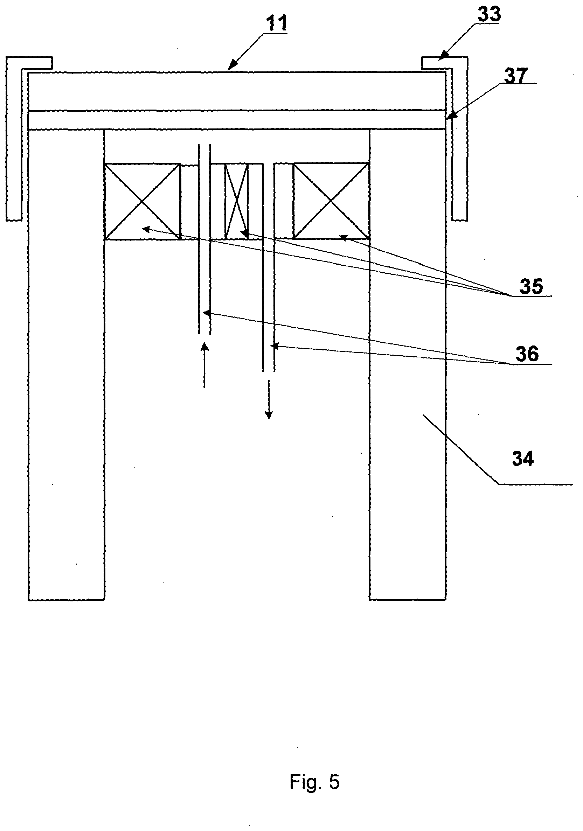

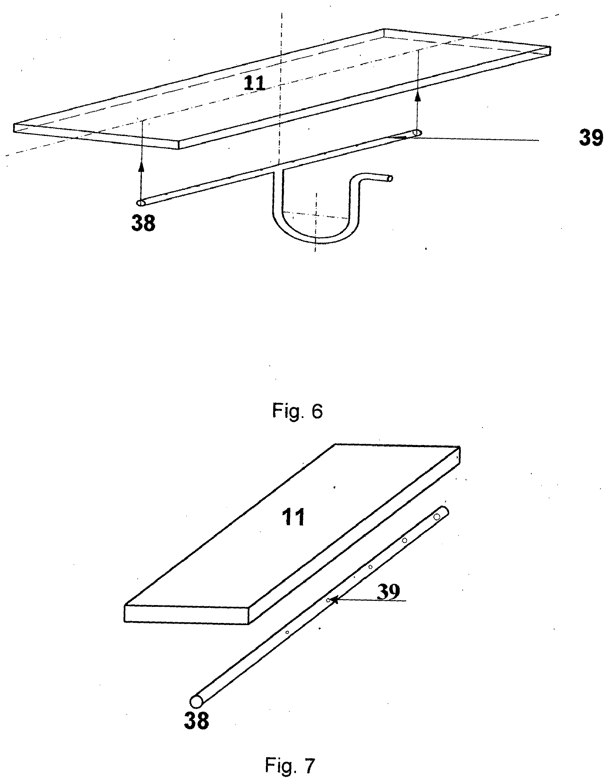

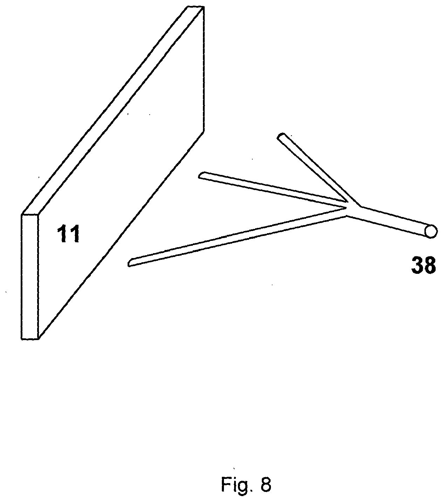

The subject of this invention is explained in examples where fig. 1 shows a scheme of the textile product, fig. 2 a scheme of the device for manufacturing of the textile product, fig. 3 vacuum chamber equipped with a conveying device and a magnetron device, fig. 4 a roller of the conveying system, fig. 5 a magnetron device, fig. 6 a metering pipe placed under the target, fig. 7 a dosing pipe connected with the U-shaped pipe and fig. 8 three metering pipes connected with a distribution pipe.

### Example 1

A textile product attenuating electromagnetic field has a substrate S made of polypropylene woven fabric (PP) with a sputtered metal coating in a form of a single layer L₁ of Zn, with a thickness of 1.5 µm.

### Example 2

A textile product attenuating electromagnetic field has a substrate S made of polypropylene nonwoven fabric (PP) with a sputtered metal coating, including two layers L₁ and L₂ with the thickness of 1 µm, made of zinc (Zn) and bismuth (Bi), respectively.

### Example 3

A textile product attenuating electromagnetic field made as in Example 1 or 2, with the difference that on a substrate S, made of polyester woven fabric, a coating including three layers L₁, L₂ and L₃ is sputtered, whereby the first one L₁ is made of zinc (Zn), the second one L₂ is made of bismuth (Bi) and the third one L₃ is made of titanium dioxide (TiO₂) which is the layer protecting against the effects of aggressive or harmful environment, especially acids, bases or moisture.

### Example 4

A textile product attenuating electromagnetic field, made as in Example 1 or 2, with the difference that on a substrate S made of polyester nonwoven fabric, a coating including three layers L₁, L₂ and L₃ is sputtered, whereby the first and the third ones L₁ and L₃ are made of zinc (Zn), and the middle, second one L₂ is made of zinc oxide (ZnO).

### Example 5

A textile product attenuating electromagnetic field made as in Example 1 or 2, with the difference that on a substrate S, made of polyamide nonwoven fabric, a coating including three layers L₁, L₂ and L₃ is sputtered, whereby the first layer L₁ is made of copper (Cu), the middle, second layer L₂ is made of zinc (Zn) and the third layer is made of nickel (Ni). The value of attenuation of electromagnetic field equals 38 dB at a frequency of 12.12 MHz, 36 dB at a frequency of 97.75 MHz and 33 dB at a frequency of 915 MHz.

### Example 6

A textile product attenuating electromagnetic field made as in Example 1 or 2, or 4, with the difference that on a substrate S made of polyester nonwoven fabric, a metal coating including four layers L₁, L₂, L₃ and L₄ is sputtered, whereby the first layer L₁ is made of aluminium (Al), the second layer L₂ is made of a nickel-iron alloy (Ni-Fe), the third layer L₃ is made of aluminium (Al) and the forth layer L₄ is made of a nickel-iron alloy (Ni-Fe).

The metallic layers L₁, L₂, L₃ and L₄ are deposited on the substrate S in an inert atmosphere of argon and the oxide layers are deposited in the process of reactive magnetron sputtering in oxygen or in a mixture of oxygen and argon.

According to the invention, layers L₁, L₂, L₃ and L₄, made of metals selected from the group including Zn, Cu, Al, Ti and Ag or a mixture of these metals or alloys selected from a group including Zn-Bi, Bi-In, Cu-Sn, Cu-Zn, Cu-Zn-Ni, Cu-Ni-Fe, and layers L₂, L₃, L₄ metals and oxides selected from a group including Zn-ZnO-Zn, Ti-TiO₂-Ti, Zn-ZnO-Zn, Zn-TiO₂-Zn and Ti-ZnO-Ti, as well as single layers L₁ in a form of coatings made of a mixture SnO₂-In₂O₃, or a mixture of ZnO-In₂O₃, are deposited on a substrate S, which is in a form of a woven fabric, nonwoven fabric or knitted fabric, having a structure assuring stable dimensions, made of polyolefine, poliester, polyamide, aramid, polyacrylonitrile fibres or combination of them. The highest values of a coefficient of electromagnetic field shielding, exceeding 50 dB, are achieved for Zn-Bi composites while the value of the coefficient for Ti, Al, Fe-Ni layers equals ca. 35 dB. Before sputtering of the layers L₁, L₂, L₃ and L₄, a substrate is preliminarily degassed using glow discharge, and the gases adsorbed on its surface are removed thus cleaning this surface. During sputtering process, the magnetron device - 1 is supplied from the magnetron supplier -27, which is a pulse current source with a power of 12 kW and the highest voltage of 1.2 kV. This source enables supplying the magnetron device 1 in two modes: unipolar DC-M, at a frequency of 160 kHz, and bipolar AC-M at a frequency of 80 kHz. The unipolar mode is used for sputtering metallic targets whereas the bipolar mode is employed in reactive processes. The current is modulated groupwise by rectangular pulses in a form of packages at a frequency of f = 2kHz (t₁= 500 ms) with the possibility of adjusting the pulse repetition frequency of the packages in the range of 50 Hz to 5 kHz (t₁= 0.02 s 200 ms). Time t₂ defines the time of target sputtering , while in the period of t₁-t₂, the material from the plasma zone is deposited on a substrate S. The ratio, t₁/t₂, is an additional technological parameter, characteristic of every reactive process. A change in its value determines a stoichiometric composition of the resulting L₂, L₃ and L₄ oxide or multi-component layers. The number and type of deposited L₂, L₃ and L₄ layers are dependent on the coefficient of shielding electromagnetic field of a textile product. Electrical parameters of oxide layers are controlled by the parameters of magnetron sputtering process whereas the number and sequence of deposited layers are arbitrary, and depend on the coefficient of electromagnetic field shielding specified for the textile product.

### Example 7

The device for manufacturing a textile product attenuating electromagnetic field has a vacuum chamber equipped with gas valves, a conveying device and a magnetron device 1, connected to a supplier 27 and a one-component target 11, placed above an anode in a shape of a part of cylindrical surface, which increases the accessibility of the deposited metals and/or metal oxides and/or their mixtures into the deeper layers of the textile substrate S. The anode, under which there is the conveying device has, on the side of the target 11, a sliding layer 5, and under this layer, a layer of supporting structure 4, whereas below the anode there is a temperature stabilizer 3, to which a cooling system made of a set of pipes transporting a cooling medium, such as water, is mounted, whereby the pipes 2 are made of copper, which is a good thermal conductive material. The temperature stabilizer 3 reduces the temperature of a coated textile substrate S. Above the three-layer anode there is the magnetron device 1, equipped with a long rectangular target 11, connected to the supplier 27 which, through a control system 26, is connected to a computer unit 25. The computer unit 25 enables recording of the technological parameters data and good repeatability of the processes of sputtering of different layers onto textile materials. The control system 26 is, through a valve controller 28, connected also to: a control valve 29, an instrument for measuring the length of a coated fabric 30 and simultaneously, through a engine velocity governor 31, with a motor 32 driving a two-way drive 9 of the conveying device. The conveying device has rollers 8, with rolled textile material 7 and it is equipped with electromagnetic clutches 13. The rollers 8 are coupled with the two-way drive 9, whereby both the rollers 8 and the drive 9 are fixed on the base 10. Each roller 8 is mounted through an insulator 24 on a driving axis 18, whereby one end of this driving axis 18 is connected to a brake disk 16, fixed to the base 10, behind which there is a spring 15 with a brake pressure controller 14, whereas the other end of the driving axis 18 is connected to a driving wheel 20, thorough the electromagnetic clutch 13 controlling the tension and the transfer speed of the textile substrate S to be coated. The electromagnetic clutch 13 has, on the side of the driving wheel 20, a clutch disk 23 and a solenoid 19 with a magnetic core 22. Furthermore, the conveying device is mounted on the base 10 on a controller of target height over a rolled textile material 7, whereby the rolled textile material 7 is situated in a plasma zone 12. The target 11 is fixed on the frame 34 of the magnetron device 1, whereby, between the target 11 and the frame 34 there is a metal foil 37 made of copper. The metal foil 37, with the thickness of 0.25 mm, is attached permanently to the frame 34 with a solder joint, and is intensively cooled with a cooling fluid provided to the area between the frame 34, the magnetic system 35 and the metal foil 37, by the cooling system 36. Below the target surface 11, on its axis and between the zones of emissive interaction of magnetic system 35 there is a metering pipe 38 dosing the working gas through the holes 39. The metering pipe 38 is connected directly to the metering valve dosing the working gas.

### Example 8

The device for manufacturing a textile product attenuating electromagnetic field is made as in the example 7, with the difference that it has a two- component target 11 which is composed of two segments in a form plates. Furthermore, the target 11 is on the earth potential, which makes possible to produce plasma, which is more directed onto the textile substrate S to be sputtered. The supplier 27, powering the magnetron device, is a sinusoidal signal converter with a pulse modulation of voltage, operating in a frequency range of 1Hz to 5 kHz. Moreover, the working gas is supplied to the target -11 with a metering pipe 38 having the outlet holes 39 with a diameter of 1 mm, which is connected to a metering valve dosing the working gas through a U-shaped pipe, whereby the length of the metering pipe 38 is less than the length of the zone of emissive interaction of the magnetic system 35, what is the reason that the material of the pipe -38 is not sputtered.

### Example 9

The device for manufacturing a textile product attenuating electromagnetic field is made as in the example 7 or 8, with the difference that the working gas is supplied below the target surface 11, between the zones of emissive interaction of the magnetic system 35, through the holes 39 of at least three metering pipes 38 connected with a distribution pipe, which is connected to the metering valve dosing the working gas.

In the magnetron sputtering device 1 operating in a pulse mode, the power dissipated in the target 11 is adjusted by the width of supplied power pulses, which assures stability of reactive processes due to elimination of uncontrolled arc discharges. As the sputtering rate is the highest during a single pulse, the pulse modulation allows increasing the sputtered material to impurity ratio. Furthermore, the employment of a resonator supplier 27 enables effective using of the power generated on the target 11. Frequency modulation of plasma enhances the sputtering process by minimizing the electrization of the material surface, especially of such insulating materials as textile products, nonwoven and the woven fabrics made of synthetic fibers like polypropylene, promoting penetration of the particles of sputtered target between the fibers, into the substrate material.
In the magnetron device 1, the target 11 and the magnetic system 35 are cooled with water by an appropriately designed cooling system 36. In the proposed invention, a copper foil 37 with the thickness below 0.25 mm, plays a role of a gasket 34 and prevents from penetration of water from the cooling system 36 to the vacuum chamber when the target 11 is damaged or broken. In long, rectangular magnetron devices 1, the basic problem is to assure a uniform concentration of a working gas ions near the surface of the target 11 so the target 11 is sputtered along the entire working surface. This problem is solved by using the metering pipe 38 with the outlet holes 39 arranged perpendicularly to the surface of the target 11.

### List of designations in the drawings:

1 magnetron device,
2 pipe with cooling medium,
3 temperature stabilizer,
4 layer of supporting structure,
5 sliding layer,
6
7 textile product,
8 roller,
9 two-way drive,
10 base,
11 target (sputtered electrode),
12 plasma zone
13 electromagnetic clutch,
14 brake pressure controller,
15 spring,
16 brake disk,
17 inlet
18 driving axis,
19 solenoid,
20 driving wheel,
21 splines,
22 magnetic core,
23 clutch disk,
24 roller insulator
25 computer,
26 process controller,
27 magnetron supplier,
28 argon valve controller,
29 argon control valve,
30 instrument for measuring the length of fabric,
31 engine velocity governor,
32 driving motor,
33 fixture,
34 frame,
35 magnetic system,
36 cooling system,
37 copper foil,
38 metering pipe,
39 outlet.

## Claims

1. A textile product attenuating electromagnetic field, in a form of a substrate with a sputtered metal coating, **characterized in that** the substrate has a deposited coating consisting of at least one layer (L₁, L₂, L₃, L₄) of Zn-Bi composite, wherein said layer has a thickness below few micrometers [µm], whereby the layers (L₁, L₂, L₃, L₄) are deposited on the substrate alternately, and the number of deposited layers (L₁, L₂, L₃, L₄) depends on the coefficient of shielding efficiency of electromagnetic field by the textile product, whereby the substrate is made of woven or nonwoven fabric of polypropylene, polyester, polyolefine, polyamide, aramid or polyacrylonitrile.

## Patentansprüche

1. Textilprodukt, das ein elektromagnetisches Feld abschwächt, in Form eines Substrats mit einer aufgesputterten Metallbeschichtung, **dadurch gekennzeichnet, dass** das Substrat eine aufgetragene Beschichtung aufweist, bestehend aus mindestens einer Lage (L₁, L₂, L₃, L₄) an Zn-Bi Komposit, wobei die Lage eine Dicke unterhalb von wenigen Mikrometern [µm] aufweist, wobei die Lagen (L₁, L₂, L₃, L₄) alternierend auf das Substrat aufgetragen werden, und die Zahl an aufgetragenen Lagen (L₁, L₂, L₃, L₄) vom Koeffizienten der Abschirmungseffizienz des elektromagnetischen Feldes durch das Textilprodukt abhängt, wobei das Substrat aus einem gewebten oder nichtgewebten Gewebe aus Polypropylen, Polyester, Polyolefin, Polyamid, Aramid oder Polyacrylnitril hergestellt ist.

## Revendications

1. Produit textile atténuant un champ électromagnétique, sous la forme d'un substrat avec un revêtement métallique obtenu par pulvérisation, **caractérisé en ce que** le substrat a un revêtement déposé constitué d'au moins une couche (L₁, L₂, L₃, L₄) d'un composite Zn-Bi, dans lequel ladite couche a une épaisseur inférieure à quelques micromètres [µm], moyennant quoi les couches (L₁, L₂, L₃, L₄) sont déposées sur le substrat en alternance, et le nombre de couches déposées (L₁, L₂, L₃, L₄) dépend du coefficient d'efficacité de protection contre le champ électromagnétique par le produit textile, moyennant quoi le substrat est fabriqué en tissu tissé ou non tissé de polypropylène, de polyester, de polyoléfine, de polyamide, d'aramide ou de polyacrylonitrile.
